# EUROPEAN PATENT SPECIFICATION

(11) **EP 0 910 113 B1**
(45) Date of publication and mention of the grant of the patent: **11.09.2002**
(21) Application number: 97117221.8
(22) Date of filing: 04.10.1997
(51) Int. Cl.: H01L 21/00

(54) **Carrier for substrate of ball-grid array integrated circuit devices**
Träger für Substrate von integrierten Schaltungsanordnungen mit Kugelmatrix
Support pour substrat de circuits intégrés à réseau de billes

(43) Date of publication of application: 21.04.1999
(73) Proprietor: UniMicron Taiwan Corp., Taipei (TW)
(72) Inventor: Cheng, David C. H., Lu-Chu Hsiang, Taoyuan Hsien (TW)
(74) Representative: Klickow, Hans-Henning

(56) References cited:
- PATENT ABSTRACTS OF JAPAN vol. 096, no. 007, 31 July 1996 -& JP 08 083819 A (EASTERN:KK), 26 March 1996,
- PATENT ABSTRACTS OF JAPAN vol. 096, no. 008, 30 August 1996 -& JP 08 097330 A (TOPPAN PRINTING CO LTD), 12 April 1996,

## Description

### 1. Field of the Invention

This invention relates in general to the fabrication of ball-grid array integrated circuit (BGA IC) devices, and, in particular, to the packing phase of the fabrication of BGA IC devices. More particularly, this invention relates to a carrier for BGA IC devices for the handling of discrete BGA printed circuit board (PCB) substrates to prevent the waste of resources and for reducing the BGA fabrication costs.

### 2. Description of Related Art

BGA is a new packaging standard for IC devices particularly suitable for high density-devices fabricated at submicron resolutions. IC devices such as the ULSI incorporate sophisticated digital circuit functionality that are built around millions of transistors. These complex circuits typically require the use of a large number of IC package pins to interface with their corresponding external circuitry. Conventional QFP (quad flat pack) and PGA (pin-grid array) ranging from less than one hundred to over two hundred pins have gradually become insufficient to use.

For example, consider the core logic circuitry for the popular 64-bit microprocessor-based personal computers. Memory paths, either the primary DRAM or the caching SRAM in these systems, employ at least a 64-bit wide data bus in order to exploit the full capability of maximum data transfer rate internal to a computer system. A core logic IC device performing memory control would thus require a pin count of well over two hundred just to meet with the need for the various versions of the memory data buses including the local, the peripheral and the system memory buses. BGA packaging is one that can fulfill these needs.

A small board based on the PCB technology constitutes the substrate for the BGA device. As persons skilled in the art should all be familiar, in the process of fabricating BGA devices, semiconductor dies must be secured to the surface of the BGA substrate by means of automated pick-and-place systems. Wire-bonding follows to connect the circuitry in the device die to the corresponding pads on the surface of the substrate. Hermetical sealing procedure than seals the die, together with all the bonding wires and the pads. After the seal is hardened and secured, solder balls for the BGA device are then formed in solder reflow units.

For most of the above-mentioned fabrication procedures, operation is implemented with the BGA substrates arranged as a bulk row. This row is contained in a frame of the PCB, frequently with all the multiplicity of BGA substrates aligned in a single row. Before being cut apart, all the substrates are connected by the PCB frame that is extra to the BGA substrates themselves. These BGA substrates will only be cut into independent ones after the bulk fabrication procedural steps are all completed.

Such bulk-processing scheme, with a multiplicity of BGA substrates integrated temporarily together, is based on at least the fact that individual BGA substrates are relatively too small to be processed efficiently when compared to normal PCB. For example, automated processing for the BGA substrates, either for the substrates themselves, or for the BGA device packaging procedural steps, requires the use of fidicial marks and fixing holes etc.. These automation means occupies relatively significant surface areas that would lead to waste of material.

On the other hand, during the automated processing for the BGA substrates, if a multiplicity of units are manipulated as a batch, the overall efficiency would be higher than single ones are. For example, consider the loading and unloading of the BGA substrate into and out of the processing facility, once every other six or more substrates is necessarily more efficient for the entire manipulation than every one substrate is loaded and unloaded.

However, as the bulk rows of BGA substrates are manufactured in the PCB facility, defects that would lead to disqualification of a substrate are inevitable due to various causes. As the locations of the defective substrates in the bulk rows are not regular in terms of their occurrences, it is generally standard procedure to discard the bulk rows of BGA substrates with any occurrence of defective substrate in a bulk row. This prevents the reduction of cost, and causes environment protection issues, as some qualified substrates in the bulk rows would have to be discarded along with those defective ones in the bulk rows with defect. Discard of qualified BGA substrates based on this practice is simply a waste of useful material and effort.

The JP 08 097330A discloses a BGA (Ball Grid Array) structure having a base composed with three layer films on one side of the substrate. The substrate is formed with a plurality of holes. The holes are formed by using a laser beam. The JP 08 083819A discloses a package for tape carrier semiconductor device. There is used a chip mounting part and a wiring pattern formed on a rigid panel made of resin. A positioning hole is opened to the tape at a specific pitch.

### SUMMARY OF THE INVENTION

It is therefore an object of the invention according to claim 1 to provide a carrier for substrate of BGA IC devices for the recovery of individual qualified BGA substrate integrated with disqualified ones in the bulk rows thereof in order to reduce overall manufacturing costs.

It is another object of the invention to provide a carrier for substrate of BGA IC devices for recovering individual BGA substrates that can be used repeatedly.

In order to achieve the above-identified objects, the invention provides a carrier for carrying discrete substrates of BGA IC devices during bulk row Ball-Grid-Array processing is disclosed. The discrete substrates are the qualified ones for recovery cut apart from bulk rows of BGA substrates with defective ones. The carrier has a number of substrate-receiving holes. The carrier has a structural dimension being the same as that of the bulk row, and the number of the substrate-receiving holes included in the carrier is the same as that of BGA substrates arranged in a bulk row. The substrate-receiving holes of the carrier is located at positions corresponding to the counterpart BGA substrate in a bulk row. The carrier salvages the qualified substrates that is integrated with defective ones in the bulk rows so that they need not be wasted.

### BRIEF DESCRIPTION OF THE DRAWINGS

Other objects, features, and advantages of the present invention will become apparent by way of the following detailed description of the preferred but non-limiting embodiments. The description is made with reference to the accompanying drawings in which:
FIG. 1 is a plane view showing the bulk row of BGA substrates with the substrates arranged in a single row;
FIG. 2 is a plane view showing the carrier for BGA substrate in accordance with a preferred embodiment of the invention; and
FIG. 3 is a partially-cut off perspective view showing the carrier for BGA substrate of FIG. 2 with BGA substrate inserted.

### DETAILED DESCRIPTION OF THE PREFERRED EMBODIMENTS

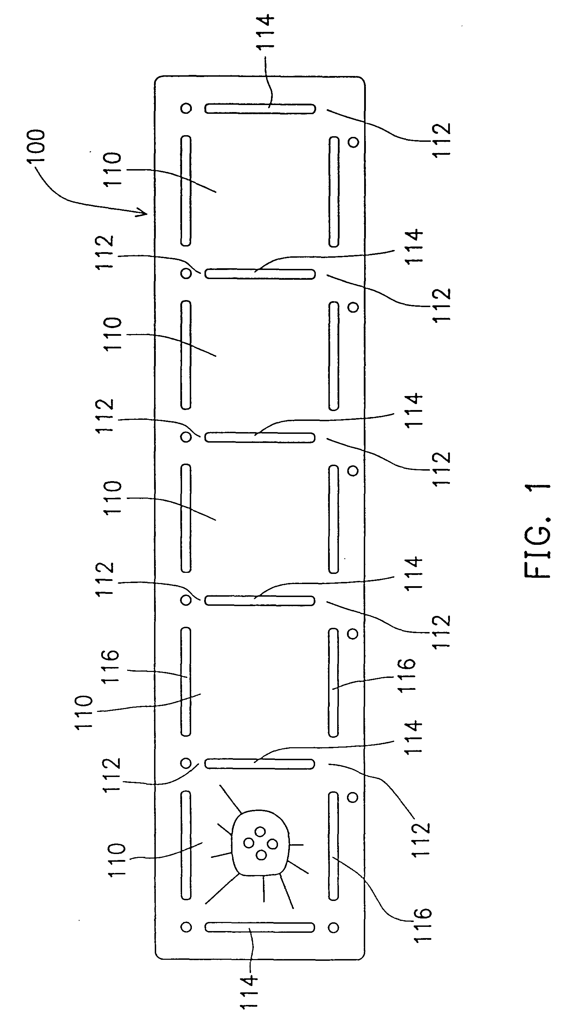

In the plane view of FIG. 1, the particular example of the bulk row 100 of BGA substrates includes a total of five substrates 110 arranged in the single row. As these substrates are not cut away yet, consecutive substrates 110 are still integrated together by the frame of PCB portions generally identified by the reference numeral 112. In comparison, the long slots 116 cut between any two consecutive substrates 110 also define the boundary of the substrates. Essentially, the area enclosed by the slots 114 and 116 perpendicular to 114 is the PCB for one BGA substrate 110 in the bulk row 100. Inner sidewalls of the slots 114 and 116 will become the sidewalls of each BGA substrate as they are cut apart at a later stage.

Whenever one or more substrates 110 in the bulk row 100 of BGA substrates are located, the particular row can be cut apart immediately, and the defective substrates discarded, while the qualified ones preserved. These collected individual BGA substrates can still be processed as their qualified counterparts in the regular bulk rows 100 utilizing the carrier of the invention, as will be described in detail in the following paragraphs. They can thus be used instead of being wasted as in the prior art processing schemes.

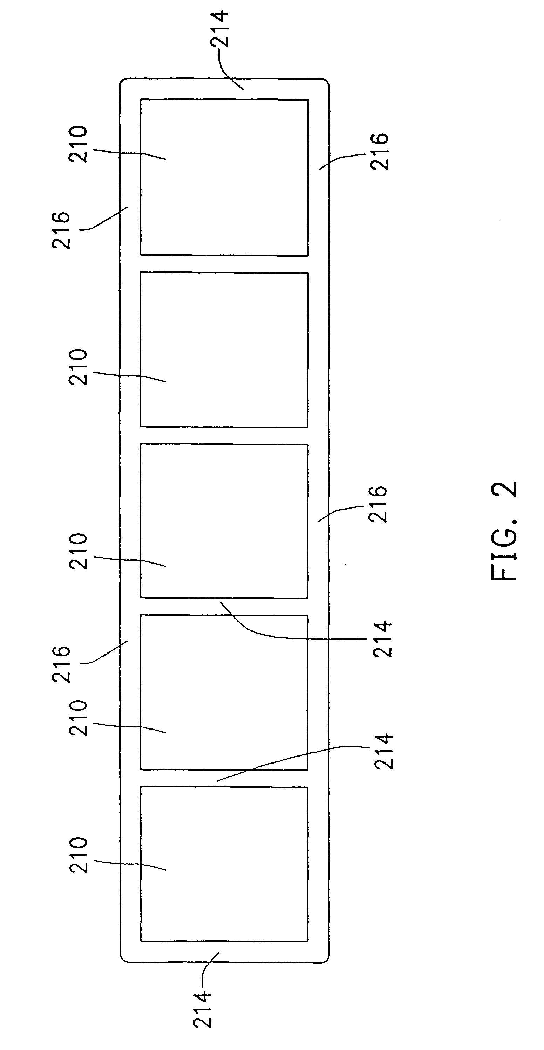

FIG. 2 is a plane view showing the carrier 200 for BGA substrate in accordance with a preferred embodiment of the invention. Note that the carrier 200 for processing discrete BGA substrates is one that is built to the specification of the BGA substrate bulk row 100 of FIG. 1. The carrier 200 may be made of sheet material such as plates of aluminum or copper alloy having comparable, or substantially the same, thickness as that of the bulk row 100.

In the embodiment of FIG. 2, the carrier 200 has opened a number of substrate-receiving holes 210 corresponding to those found on the bulk row 100 of FIG. 1, a total of five, specifically. Each of the substrate-receiving holes 210 has an opening with the dimension substantially compatible with the outer dimension of the BGA substrates found in the bulk row 100 as they are cut apart. The dimensioning of the substrate-receiving holes in the carrier 200 is such that each of the holes can receive the insertion of a BGA substrate 110 easily and firmly. In other words, each of the substrate-receiving holes 210 on the carrier 200, as is enclosed by the surrounding elongated sections of PCB 214 and 216, can receive the insertion of a discrete BGA substrate 110 as cut apart from those bulk rows 100 containing defective ones.

Carriers 200 with discrete BGA substrates 110 inserted may have one surface thereof attached by a piece of adhesive tape having adequate surface area. This assists in the securing of the insertion of BGA substrates 110 in the substrate-receiving holes 210 of the carrier 200. With the assistance of the adhesive tape, the carrier 200 having discrete BGA substrates 110 inserted may exhibit sufficient rigidity so as to be processed as the regular bulk rows 100 in the automated procedural steps of BGA IC device packaging operations.

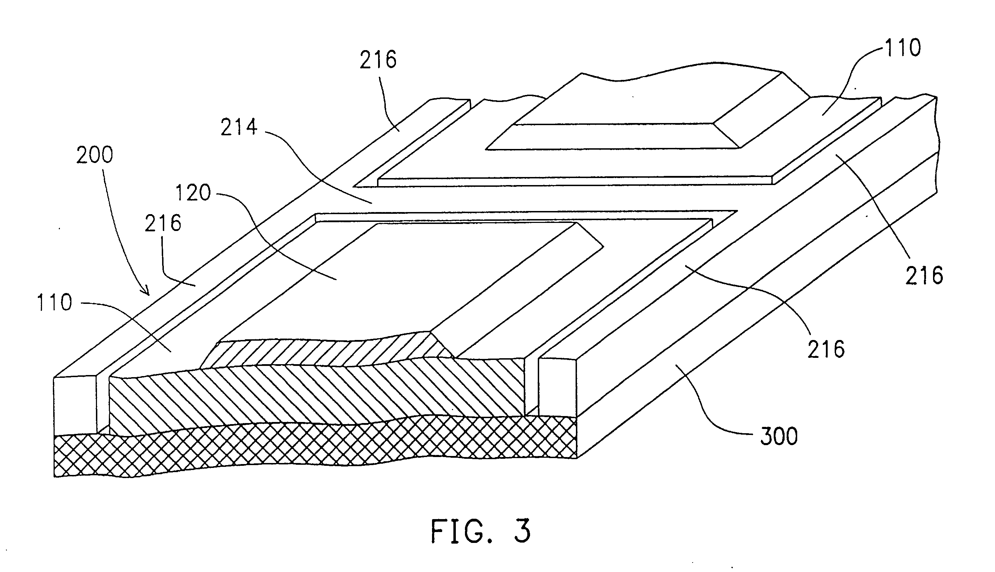

FIG. 3 is a partially-cut off perspective view showing the carrier 200 for BGA substrate of FIG. 2 with BGA substrate 110 already inserted. The drawing also shows that adhesive tape 300 is used to assist in securing the substrates 110 in place as mentioned above. The BGA substrate 110 shown in FIG. 3 has the semiconductor die already placed in position, the wire-bonding operation completed, and the hermetically sealing 120 established.

Certainly, what is illustrated in FIG. 3 demonstrates how the carrier 200 of the invention can be used in the process of hermetically sealing. However, as persons skilled in the art should all appreciate, the carrier 200 can also be used for manipulations such as semiconductor die pick-and-place, as well as wire-bonding.

As all the necessary fabrication procedural steps are completed, each of the BGA substrate 110 can be removed from the carrier 200. This require the removal of the adhesive tape 300, and removing each of the BGA substrates 110 from the substrate-receiving holes 210 in the carrier 200. After clearing all the BGA substrates 110, the carrier 200 is well reusable again. In other words, the carrier 200 can be used along with another batch of BGA substrates 110 in another processing step.

As persons skilled in the art may well appreciate, different dimensional requirements for different BGA devices may be implemented into a carrier of the invention. These dimensional factors include the size of the bulk row, the size of the BGA substrate involved, as well as the number of substrates arranged in the row, etc...

While the invention has been described in terms of preferred embodiment, it is to be understood that the invention need not be limited to the disclosed embodiments.

## Claims

1. A carrier (200) for carrying discrete substrates (110) of Ball-Grid Array (BGA) IC devices during bulk row Ball-Grid-Array processing, the discrete substrates (110) being the qualified ones for recovery, the cut apart from bulk rows (100) of BGA substrates (110), wherein the carrier (200) comprises a plurality of substrate-receiving holes (210),
the carrier (200) has a structural dimension being the same as the bulk row (100);
the number of the plurality of substrate-receiving holes (210) included in the carrier (200) being the same as the number of BGA substrates (110) arranged in a bulk row (100); and
in the substrate-receiving holes (210) of the carrier (200) being located at positions corresponding to the counterpart BGA substrate (110) in a bulk row (100).

2. The carrier (200) for BGA substrate (110) of claim 1, further comprising a securing layer (300) at the bottom surface of the carrier.

3. The carrier (200) for BGA of claim 2, wherein the securing layer is an adhesive tape (300).

4. The carrier (200) for BGA substrate (110) of claim 1, wherein the thickness of the carrier (200) is the same as that of the bulk row (100).

5. The carrier (200) for BGA substrate (110) of claim 1, wherein the carrier (200) is made of a plate of copper alloy.

6. The carrier (200) for BGA substrate (110) of claim 1, wherein the carrier (200) is made of a plate of aluminum alloy.

## Patentansprüche

1. Träger (200) zur Aufnahme getrennter Substrate (110) von integrierten Schaltungsanordnungen mit Kugelmatrix-Anordnung (Ball-Grid-Array, BGA) während der Herstellung von Volumenreihen einer Kugelmatrix-Anordnung, wobei die getrennten Substrate (110) diejenigen sind, die für die Weiterverwendung vorgesehen sind und die von den Volumenreihen (100) der BGA-Substrate (110) abgeschnitten werden, wobei der Träger (200) eine Anzahl von Bohrungen (210) für die Aufnahme des Substrates aufweist, wobei der Träger (200) dieselbe strukturelle Dimension aufweist wie die Volumenreihe (100), wobei die Anzahl der Bohrungen (210) für die Aufnahme des Substrates in dem Träger (200) die gleiche ist wie die Anzahl der BGA-Substrate (110), die in einer Volumenreihe (100) angeordnet sind, und wobei die Bohrungen (210) des Trägers (200) für die Aufnahme des Substrates in Positionen angeordnet sind, die dem zugeordneten BGA-Substrat (110) in einer Volumenreihe (100) entsprechen.

2. Träger (200) für BGA-Substrate (110) gemäß Anspruch 1, wobei weiterhin eine Sicherungsschicht (300) an der Bodenfläche des Trägers vorgesehen ist.

3. Träger (200) für BGA-Substrate (110) gemäß Anspruch 2, wobei die Sicherungsschicht (300) aus einem Klebeband (300) besteht.

4. Träger (200) für BGA-Substrate (110) gemäß Anspruch 1, wobei die Stärke des Trägers (200) dieselbe ist wie diejenige der Volumenreihe (100).

5. Träger (200) für BGA-Substrate (110) gemäß Anspruch 1, wobei der Träger (200) aus einer Platte einer Kupferlegierung besteht.

6. Träger (200) für BGA-Substrate (110) gemäß Anspruch 1, wobei der Träger (200) aus einer Platte einer Aluminiumlegierung besteht.

## Revendications

1. Un support (200) pour porter des substrats discrets (110) de circuits intégrés à réseau de billes (ou BGA pour "Ball-Grid Array") pendant le traitement en rangée collective, les substrats discrets (110) étant ceux qui sont qualifiés pour la récupération, en étant détachés de rangées collectives (100) de substrats BGA (110), dans lequel le support (200) comprend une multiplicité de trous de réception de substrats (210),
le support (200) a une dimension structurale qui est la même que celle de la rangée collective (100);
le nombre de la multiplicité de trous de réception de substrats (210) inclus dans le support (200) étant le même que le nombre de substrats BGA (110) disposés dans une rangée collective (100); et
les trous de réception de substrats (210) du support (200) étant placés à des positions correspondant au substrat BGA (110) associé dans une rangée collective (100).

2. Le support (200) pour des substrats BGA (110) de la revendication 1, comprenant en outre une couche de fixation (300) à la surface inférieure du support.

3. Le support (200) pour des substrats BGA de la revendication 2. dans lequel la couche de fixation est une bande adhésive (300).

4. Le support (200) pour des substrats BGA (110) de la revendication 1, dans lequel l'épaisseur du support (200) est la même que celle de la rangée collective (100).

5. Le support (200) pour des substrats BGA (110) de la revendication 1, dans lequel le support (200) est constitué d'une plaque d'alliage de cuivre.

6. Le support (200) pour des substrats BGA (110) de la revendication 1, dans lequel le support (200) est constitué d'une plaque d'alliage d'aluminium.
